(19) Europäisches Patentamt

European Patent Office

Office européen des brevets

(11) **EP 1 229 340 B1**

(12) **EUROPÄISCHE PATENTSCHRIFT**

(45) Veröffentlichungstag und Bekanntmachung des Hinweises auf die Patenterteilung:
**21.06.2006  Patentblatt 2006/25**

(51) Int Cl.:
***G01R 33/387*** *(2006.01)*

(21) Anmeldenummer: **01127522.9**

(22) Anmeldetag: **17.11.2001**

(54) **Magnetanordnung mit einem supraleitenden Magnetspulensystem und einer magnetischen Feldformvorrichtung für hochauflösende magnetische Resonanzspektroskopie**

Magnet assembly with a superconducting magnet coil system and a magnetic field forming device for high resolution magnetic resonance spectroscopy

Agencement d'aimants avec un système de bobines supraconductrices et un dispositif d'ajustage du champ magnétique pour la spectroscopie par résonance magnétique à haute résolution

(84) Benannte Vertragsstaaten:
**CH DE FR GB LI**

(30) Priorität: **31.01.2001  DE 10104054**

(43) Veröffentlichungstag der Anmeldung:
**07.08.2002  Patentblatt 2002/32**

(73) Patentinhaber: **Bruker BioSpin AG**
**8117 Fällanden (CH)**

(72) Erfinder:
- **Bovier, Pierre-Alain**
  **8051 Zürich (CH)**
- **Schauwecker, Robert**
  **8032 Zürich (CH)**
- **Amann, Andreas**
  **8008 Zürich (CH)**
- **Eckert, Daniel M.**
  **8600 Dübendorf (CH)**

(74) Vertreter: **Kohler Schmid Möbus**
**Patentanwälte**
**Ruppmannstrasse 27**
**70565 Stuttgart (DE)**

(56) Entgegenhaltungen:
| | |
|---|---|
| EP-A- 0 619 500 | EP-A- 0 715 180 |
| US-A- 6 084 497 | US-A- 6 163 154 |

- BOBROV E S ET AL: "A 60cm Bore 2.0 Tesla High Homogeneity Magnet for Magnetic Resonance Imaging" IEEE TRANSACTIONS ON MAGNETICS, IEEE INC. NEW YORK, US, Bd. MAG-23, Nr. 2, 1987, Seiten 1303-1308, XP002229095 ISSN: 0018-9464

EP 1 229 340 B1

**Beschreibung**

Die Erfindung betrifft eine Magnetanordnung mit einem supraleitenden Magnetspulensystem zur Erzeugung eines Magnetfeldes in Richtung einer $z$-Achse in einem auf der $z$-Achse um $z = 0$ angeordneten Arbeitsvolumen, wobei das Feld des Magnetspulensystems im Arbeitsvolumen mindestens einen inhomogenen Anteil $H_n \cdot z^n$ mit $n \geq 2$ aufweist, dessen Beitrag zur Gesamtfeldstärke auf der $z$-Achse um $z = 0$ mit der $n$-ten Potenz von $z$ variiert, und wobei eine bezüglich der $z$-Achse bis auf eine Fertigungstoleranz zylindersymmetrische Feldformvorrichtung aus magnetischem Material vorgesehen ist, sowie ein Verfahren zur Bestimmung der Fertigungstoleranzen der magnetischen Feldformvorrichtung.

Eine solche Anordnung mit einem supraleitenden Magnetspulensystem und einer magnetischen Feldformvorrichtung ist bekannt aus der US 5'396'208.

Das Einsatzgebiet von supraleitenden Magneten umfasst verschiedene Anwendungsfelder. Dazu gehören insbesondere Magnetresonanzverfahren, wobei zwischen bildgebenden Verfahren (Magnetic Resonance Imaging, MRI) und spektroskopischen Verfahren unterschieden wird. Um in solchen Verfahren eine gute örtliche bzw. spektrale Auflösung zu erreichen, muss das Magnetfeld im Probenvolumen eine gute Homogenität aufweisen. Mit der geometrischen Anordnung der felderzeugenden Magnetspulen kann die Grundhomogenität des supraleitenden Magneten optimiert werden. Typischerweise müssen Aussparungen vorgesehen werden (sogenannte Notchstrukturen), in denen kein Draht gewickelt wird. So geht Platz für Magnetwicklungen verloren, was den Magneten verteuert und das Streufeld vergrößert.

In der Patentschrift US 6,084,497 wird eine Magnetanordnung für Magnetresonanzspektroskopie beschrieben, die mittels Spulen mit negativem Strom homogenisiert wird. Dadurch wird eine kompaktere Magnetanordnung als mit üblichen Notchstrukturen möglich. Ferner wird von Bobrov ES et al in "IEEE Trans. Magn., Vol. MAG-23, pp 1303-1308 (1987)" ein Shimverfahren mit ferromagnetischen Elementen im Bore eines MRI Systems beschrieben.

In einer Anordnung gemäß US 5'396'208 wird ein MRI System dadurch kompakter gestaltet, dass mehrere weichmagnetische Ringe vorgesehen sind, welche die Rolle gewisser Notchstrukturen übernehmen. Mit diesen weichmagnetischen Ringen ist es möglich, die Ausdehnung des supraleitenden Spulensystems in Richtung der Magnetachse derart zu reduzieren, dass das System einen Öffnungswinkel von etwa 90 Grad aufweist. Ein großer Öffnungswinkel bei MRI-Magnetsystemen ist unter anderem deshalb vorteilhaft, weil so einer allfälligen Platzangst von Patienten entgegengewirkt werden kann, sollte das Magnetsystem in der humanmedizinischen Diagnostik eingesetzt werden.

Will man die Idee der US 5'396'208, dass ein Magnetspulensystem effizienter mit einer magnetischen Feldformvorrichtung homogenisiert werden kann als mit Notchstrukturen, auf eine Magnetanordnung für hochauflösende Resonanzspektroskopie statt auf ein MRI-Magnetsystem anwenden, sieht man sich mit neuen Problemen konfrontiert. Um eine hinreichend effiziente Feldformvorrichtung aus magnetischem Material zu erhalten, müssen typischerweise mindestens Teile dieser Feldformvorrichtung nahe am Arbeitsvolumen der Magnetanordnung angebracht werden. Diese Teile der Feldformvorrichtung können aber wegen fertigungsbedingter Ungenauigkeiten neben dem gewünschten Magnetfeld auch unerwünschte örtliche Verzerrungen des Magnetfeldes im Arbeitsvolumen der Magnetanordnung erzeugen. Dieses Problem macht sich in hochauflösenden resonanzspektroskopischen Anwendungen vor allem aus den folgenden zwei Gründen typischerweise viel stärker bemerkbar als in MRI-Anwendungen. Einerseits sind die Homogenitätsanforderungen an eine Magnetanordnung für hochauflösende Resonanzspektroskopie wesentlich höher als die an ein MRI System gestellten (typischerweise $2 \cdot 10^{-4}$ ppm in einem Arbeitsvolumen von 0.2 cm$^3$ gegenüber 5 ppm in einem Arbeitsvolumen von 34 Litern für MRI Systeme). Andererseits wird die gewünschte Feldformwirkung der magnetischen Feldformvorrichtung in einer Magnetanordnung für hochauflösende Resonanzspektroskopie aufgrund der kompakteren Abmessungen typischerweise mit viel weniger magnetischem Material erzielt als dies in einer MRI-Magnetanordnung der Fall ist. Deshalb werden auch unerwünschte Feldverzerrungen in viel größerem Maße auftreten, wenn die Position einer bestimmten Menge magnetischen Materials der Feldformvorrichtung um einen bestimmten Betrag von der vorgesehenen Position abweicht. Mit anderen Worten: die Effizienz der magnetischen Feldformvorrichtung ist sowohl hinsichtlich ihrer gewünschten als auch ihrer unerwünschten Wirkungen größer.

Aufgabe der vorliegenden Erfindung ist es, in einer Magnetanordnung für hochauflösende Resonanzspektroskopie eine Feldformvorrichtung aus magnetischem Material mit geeigneter Geometrie zu verwirklichen, so dass im Magnetspulensystem auf mindestens einen Teil der Notchstrukturen zur Feldhomogenisierung verzichtet werden kann, und dass der Einfluss von unvermeidlichen Fertigungsungenauigkeiten der magnetischen Feldformvorrichtung auf das Magnetfeldprofil im Arbeitsvolumen hinreichend kompensiert werden kann.

Erfindungsgemäß wird diese Aufgabe dadurch gelöst, dass die Feldformvorrichtung mindestens teilweise einen radialen Abstand von der $z$-Achse von weniger als 80 Millimetern besitzt und mindestens einen der inhomogenen Feldanteile $H_n \cdot z^n$ des Magnetspulensystems zu mindestens fünfzig Prozent kompensiert, dass mindestens ein zusätzliches Spulensystem vorgesehen ist, welches in der Magnetanordnung als Shim-Vorrichtung wirkt, und dass die tatsächlichen Oberflächen der Feldformvorrichtung an jedem Ort um höchstens $\Delta_P$ von den vorgesehenen Oberflächen abweichen, wobei $\Delta_P$ durch

$$\Delta_P = 0.2 \cdot \frac{\iiint_C |\Delta_C(r,z,\varphi)| \cdot \dfrac{|J_C(r,z,\varphi)|}{(r^2+z^2)^{1+k/2}} dV}{\iiint_P \dfrac{|\vec{\nabla} \times \overrightarrow{M}(r,z,\varphi)|}{(r^2+z^2)^{1+k/2}} dV}$$

gegeben ist, mit

$\Delta_C$    Fertigungstoleranz für die maximale (radiale oder axiale) Verschiebung eines Volumenelementes $dV$ der Magnetwicklung im Magnetspulensystem,

$k$    niedrigster Grad außer Null all jener Koeffizienten des Feldes des Magnetspulensystems in der Entwicklung nach Kugelfunktionen, zu deren Kompensation kein Shimspulensystem vorgesehen ist, wobei der Grad den unteren Index der, in der entsprechenden Kugelfunktion auftretenden, Legendre-Funktion $P_k^m$ bezeichnet,

$J_C$    Stromdichte im Magnetspulensystem,

$\overrightarrow{M}$    Magnetisierung der Feldformvorrichtung,

$r$    radialer Abstand des Volumenelementes $dV$ von der $z$-Achse,

$\varphi$    azimutaler Winkel des Volumenelementes $dV$.

$\iiint_C \ldots dV$   bzw.   $\iiint_P \ldots dV$ : Volumenintegral über das Volumen des Magnetspulensystems bzw. der Feldformvorrichtung.

Mindestens einer der im Magnetspulensystem wegen des Verzichts auf Notchstrukturen auftretenden inhomogenen Feldanteile wird mit einer magnetischen Feldformvorrichtung zu mindestens fünfzig Prozent kompensiert. Die inhomogenen Feldanteile sind von der Form $H_n \cdot z^n$ mit $n \geq 2$, das heißt, ihre Beiträge zur Gesamtfeldstärke des Magnetspulensystems variieren auf der Magnetachse ($z$-Achse) um $z = 0$ mit der $n$-ten Potenz von $z$.

Der Vorteil einer Magnetanordnung mit einer solchermaßen positionierten magnetischen Feldformvorrichtung besteht darin, dass insbesondere auch Feldinhomogenitäten $H_n \cdot z^n$ mit $n \geq 4$ mit geringen Mengen magnetischen Materials kompensiert werden können, wohingegen die Effizienz der Feldformvorrichtung zur Kompensation solcher Feldinhomogenitäten drastisch abnähme, würde die Feldformvorrichtung gänzlich in größerem Abstand als 80 Millimeter von der Magnetachse positioniert.

Das obige Integral über das Volumen des Magnetspulensystems ist ein Maß für die Feldverzerrungen im Arbeitsvolumen der Magnetanordnung, welche von fertigungsbedingten Positionsabweichungen der Drahtwindungen im Magnetspulensystem von ihren Sollpositionen herrühren. Das entsprechende Integral über das Volumen der magnetischen Feldformvorrichtung ist ein Maß für die Feldverzerrungen, welche von fertigungsbedingten Ungenauigkeiten der Oberflächen der Feldformvorrichtung herrühren. Wenn die tatsächlichen Oberflächen der Feldformvorrichtung von den vorgesehenen überall um weniger als den gemäß obiger Formel berechneten Betrag $\Delta_P$ abweichen, ist gewährleistet, dass die Feldformvorrichtung im Arbeitsvolumen im Wesentlichen nur solche unerwünschten, fertigungsbedingten Feldverzerrungen erzeugt, welche mit den zusätzlich vorhandenen Shimvorrichtungen kompensiert werden können. Die Feldverzerrungen höherer Ordnung bleiben kleiner als zwanzig Prozent jener Feldverzerrungen, welche im Arbeitsvolumen der Magnetanordnung auch ohne die magnetische Feldformvorrichtung vorhanden wären und können daher als tolerierbar betrachtet werden.

Besonders vorteilhaft ist auch eine Ausführungsform der erfindungsgemäßen Magnetanordnung, bei der das Magnetspulensystem eine aktive Abschirmung besitzt. Diese aktive Abschirmung reduziert das Streufeld der Magnetanordnung, so dass im Labor mehr Platz für andere Anwendungen zur Verfügung steht.

In einer besonders bevorzugten Ausführungsform der erfindungsgemäßen Magnetanordnung wird die Magnetanordnung mit einer passiven Abschirmung ausgestattet. Die passive Abschirmung hat gegenüber der aktiven Abschirmung den großen Vorteil, dass sie im Arbeitsvolumen das Feld sogar verstärkt.

Eine weitere bevorzugte Ausführungsform der erfindungsgemäßen Magnetanordnung zeichnet sich dadurch aus, dass die Feldformvorrichtung mindestens teilweise radial innerhalb der innersten Drahtwindung des Magnetspulensystems angeordnet ist. So nah an der $z$-Achse ist die Effizienz der Feldformvorrichtung für die Kompensation der inhomogenen Feldanteile $H_n \cdot z^n$ des Magnetspulensystems besonders groß.

Vorteilhaft ist auch eine Ausführungsform der erfindungsgemäßen Magnetanordnung, bei der die Feldformvorrichtung magnetisch vollständig gesättigt und rein axial (in einer Richtung entlang der $z$-Achse) magnetisiert ist. In dieser Situation ist die Berechnung des durch die Feldformvorrichtung produzierten Feldes besonders einfach und exakt.

In zwei weiteren Ausführungsformen zeichnet sich die Magnetanordnung dadurch aus, dass das Magnetfeld der Feldformvorrichtung einen Anteil $H_4 \cdot z^4$ aufweist mit $H_4 > 0$, dessen Feldbeitrag auf der $z$-Achse um $z = 0$ mit der vierten Potenz von $z$ variiert. Zusätzlich sind in diesen beiden Ausführungsformen die Anteile $H_6 \cdot z^6$ des Magnetfeldes der Feldformvorrichtung im Wesentlichen Null. Diese Ausführungsformen haben einerseits den Vorteil, dass dank des positiven Beitrags $H_4 \cdot z^4$ der Feldformvorrichtung zum Gesamtfeld der Magnetanordnung mindestens teilweise auf die typischerweise besonders komplizierten Notchstrukturen im Magnetspulensystem verzichtet werden kann, mit welchen sonst die negativen Feldbeiträge vierten Grades des Magnetspulensystems kompensiert werden müssten. Andererseits wird durch den verschwindenden Anteil sechsten Grades der Feldformvorrichtung gewährleistet, dass der Anteil sechsten Grades der Magnetanordnung durch die Feldformvorrichtung nicht vergrößert wird. Dies ist darum wichtig, weil typischerweise dieser Anteil des Magnetfeldes die Größe jenes Volumens bestimmt, in welchem das Feld der Magnetanordnung eine Homogenität aufweist, welche für die hochauflösende Resonanzspektroskopie benötigt wird.

Eine solche Feldformvorrichtung besteht in einer besonders bevorzugten Ausführungsform aus einem Ring, welcher sich auf einem Radius a befindet und sich axial zwischen $-z_1$ und $z_1$ erstreckt, wobei $z_1 > a$. Die einfache Geometrie der Feldformvorrichtung macht diese Lösung besonders attraktiv.

In einer weiteren vorteilhaften Ausführungsform der erfindungsgemäßen Magnetanordnung umfasst die Feldformvorrichtung zwei Ringe, welche sich auf einem Radius a befinden und sich axial zwischen $z_1$ und $z_2$ bzw. zwischen $-z_2$ und $-z_1$ erstrecken, wobei $0.42\,a < z_1 < 0.46\,a$ und $a < z_2$. Wie in der vorher zitierten Ausführungsform gibt eine solche Feldformvorrichtung nur einen kleinen Beitrag der Form $H_6 \cdot z^6$ zum Feld im Probenvolumen. Der Feldbeitrag der Form $H_4 \cdot z^4$ mit $H_4 > 0$ ist aber deutlich größer als in der vorigen Ausführungsform.

In einer weiteren vorteilhaften Ausführungsform der erfindungsgemäßen Magnetanordnung umfasst die Feldformvorrichtung Komponenten aus Weicheisen. Weicheisen hat als Vorteile eine große Permeabilität sowie eine hohe Sättigungsinduktion. Mit diesen Eigenschaften bekommt die Feldformvorrichtung eine hohe Magnetisierung, so dass mit wenig Material schon eine hohe Feldeffizienz erreicht wird.

Vorteilhaft ist auch eine Ausführungsform der erfindungsgemäßen Magnetanordnung, bei der Teile der Feldformvorrichtung einer Oberflächenbehandlung unterzogen wurden, insbesondere dass diese verzinkt wurden. Diese Oberflächenbehandlung bietet einen optimalen Schutz vor Korrosion, was insbesondere für Teile aus Weicheisen unerlässlich ist.

Eine besonders bevorzugte Ausführungsform der erfindungsgemäßen Magnetanordnung zeichnet sich dadurch aus, dass die Feldformvorrichtung aus einem einzigen Element aus magnetischem Material besteht. Dies ist hinsichtlich der Fertigung und Montage die einfachst mögliche Ausführungsform für die Feldformvorrichtung.

Vorteilhaft ist auch eine Ausführungsform der erfindungsgemäßen Magnetanordnung, bei der die Feldformvorrichtung mehrere Elemente aus magnetischem Material umfasst. Dadurch bieten sich mehr Freiheitsgrade für die Optimierung der Feldformvorrichtung.

In einer weiteren vorteilhaften Ausführungsform der erfindungsgemäßen Magnetanordnung umfasst die Feldformvorrichtung magnetische Folien, welche auf einer Trägervorrichtung angebracht sind. Besonders nahe an der $z$-Achse ist die Effizienz von magnetischem Material so groß, dass wenig Material für die Erzeugung der gewünschten Feldform notwendig ist. Folien bieten daher eine ideale Lösung nicht zuletzt darum, weil sie nur geringe Schwankungen in der Dicke aufweisen.

Zwei weitere vorteilhafte Ausführungsformen der erfindungsgemäßen Magnetanordnung zeichnen sich dadurch aus, dass bestehende Komponenten der Magnetanordnung für die Feldformvorrichtung genutzt werden: In der ersten umfasst die Feldformvorrichtung Komponenten, die Teil eines Spulenkörpers des Magnetspulensystems sind. Zum Beispiel kann auf eine Trägervorrichtung magnetisches Material aufgedampft werden.

In der zweiten Ausführungsform umfasst die Feldformvorrichtung Komponenten, die Teil des Kryostaten, in welchem das Magnetspulensystem untergebracht ist, sind. Beide Ausführungsformen haben den Vorteil, dass keine zusätzlichen Teile für die Feldformvorrichtung benötigt werden und damit Platz beispielsweise für Magnetwindungen gespart werden kann.

In einer weiteren Ausführungsform zeichnet sich die Magnetanordnung dadurch aus, dass die Feldformvorrichtung Komponenten umfasst, die in einem Bereich der Magnetanordnung, welche sich auf Raumtemperatur befindet, angebracht sind. Diese Komponenten sind im Betriebszustand gut zugänglich und können modifiziert werden, ohne das Magnetspulensystem aufzuwärmen.

Eine besonders bevorzugte Ausführungsform der erfindungsgemäßen Magnetanordnung zeichnet sich dadurch aus, dass die Feldformvorrichtung gekühlte Komponenten umfasst, insbesondere derart, dass diese die Temperatur des Flüssighelium-Bades, welches das Magnetspulensystem kühlt, aufweisen. Der Vorteil der tiefen Temperatur sind bessere magnetische Eigenschaften des magnetischen Materials, das heißt eine größere Magnetisierung bei gegebenem äußerem Feld. Bei stabiler Temperatur werden auch Schwankungen in der Magnetisierung unterdrückt, was eine bessere zeitliche Stabilität der Homogenität der Magnetanordnung gewährleistet.

In den Rahmen der vorliegenden Erfindung fällt auch ein Verfahren zur Bestimmung der Fertigungstoleranzen der magnetischen Feldformvorrichtung in einer Magnetanordnung nach einem der Ansprüche 1-8, welches dadurch gekennzeichnet ist, dass die Größe $\Delta_P$, welche die maximale Fertigungstoleranz der tatsächlichen Oberflächen der Feldformvorrichtung an jedem Ort bezeichnet, berechnet wird, wobei $\Delta_P$ durch

$$\Delta_P = 0.2 \cdot \frac{\iiint_C |\Delta_C(r,z,\varphi)| \cdot \frac{|J_C(r,z,\varphi)|}{(r^2+z^2)^{1+k/2}} dV}{\iiint_P \frac{|\vec{\nabla} \times \overrightarrow{M}(r,z,\varphi)|}{(r^2+z^2)^{1+k/2}} dV}$$

gegeben ist, mit

$\Delta_C$     Fertigungstoleranz für die maximale (radiale oder axiale) Verschiebung eines Volumenelementes $dV$ der Magnetwicklung im Magnetspulensystem,

$k$     niedrigster Grad äußer Null all jener Koeffizienten des Feldes des Magnetspulensystems in der Entwicklung nach Kugelfunktionen, zu deren Kompensation kein Shimspulensystem vorgesehen ist, wobei der Grad den unteren Index der, in der entsprechenden Kugelfunktion auftretenden, Legendre-Funktion $P_k^m$ bezeichnet,

$J_C$     Stromdichte im Magnetspulensystem,

$\overrightarrow{M}$     Magnetisierung der Feldformvorrichtung,

$r$     radialer Abstand des Volumenelementes $dV$ von der $z$-Achse,

$\varphi$     azimutaler Winkel des Volumenelementes $dV$.

$\iiint_C ...dV$ bzw. $\iiint_P ...dV$ : Volumenintegral über das Volumen des Magnetspulensystems bzw. der Feldformvorrichtung.

Durch Einhaltung der so ermittelten Fertigungstoleranzen für die magnetische Feldformvorrichtung kann gewährleistet werden, dass die Feldformvorrichtung im Arbeitsvolumen im Wesentlichen nur solche unerwünschten, fertigungsbedingten Feldverzerrungen erzeugt, welche mit den zusätzlich vorhandenen Shimvorrichtungen kompensiert werden können, und dass die Feldverzerrungen höheren Grades kleiner bleiben als zwanzig Prozent jener Feldverzerrungen, welche im Arbeitsvolumen der Magnetanordnung auch ohne die magnetische Feldformvorrichtung vorhanden wären.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:

Fig. 1 einen schematischen Vertikalschnitt durch eine radiale Hälfte der erfindungsgemäßen Magnetanordnung;

Fig. 2 die Funktionen $H_n(s)$ mit denen sich das Feldprofil einer aus ringförmigen Elementen aufgebauten Feldformvorrichtung aus rein axial magnetisiertem Material bestimmen lässt.

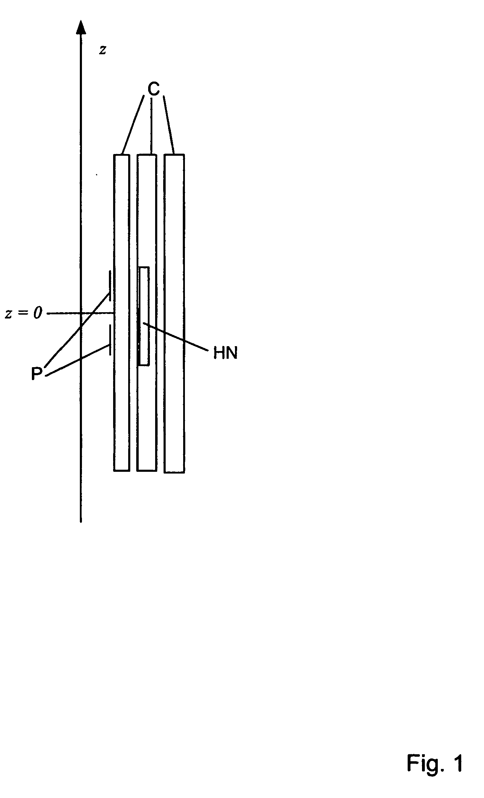

Anhand der Figur 1 wird eine erfindungsgemäße Magnetanordnung gezeigt, welche ein Magnetspulensystem $C$ sowie eine magnetische Feldformvorrichtung $P$ umfasst. Die Feldformvorrichtung $P$ liegt typischerweise zumindest teilweise näher an der $z$-Achse als das Magnetspulensystem $C$. In der mittleren Sektion ist ein sogenannter Halfnotch $HN$ (Bereich mit halber Stromdichte) eingezeichnet, welcher für die Erzeugung eines homogenen Feldes im Probenvolumen erforderlich ist.

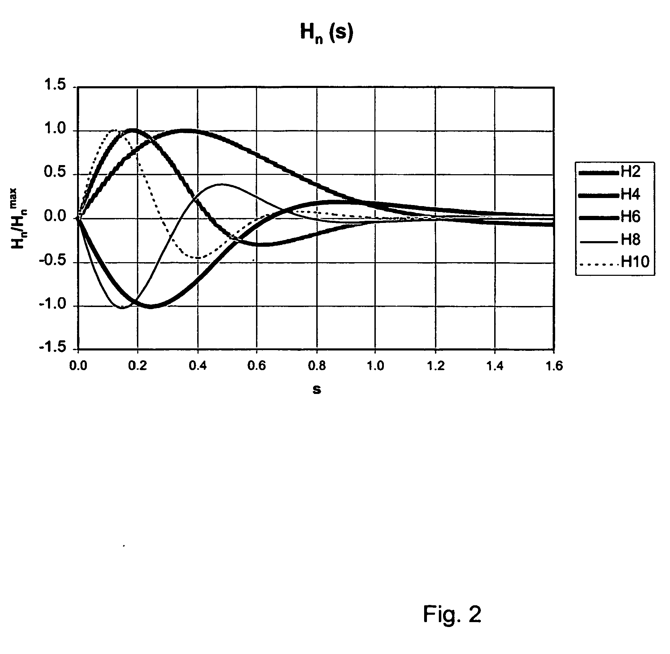

Figur 2 zeigt die skalierten Funktionen $H_n(s)$, welche für dünnwandige rein axial magnetisierte zylinderförmige Feldformvorrichtungen den Feldanteil $H_n(s)z^n$ im Probenvolumen angeben. Die dimensionslose Größe s ist das Verhältnis der axialen Länge zum Durchmesser einer dünnwandigen zylinderförmigen Feldformvorrichtung, welche um $z$

= 0 zentriert ist. Um die Darstellung der Kurvenschar zu ermöglichen, wurden alle Funktionen auf 1 skaliert.

Im Folgenden wird die Erfindung anhand von zwei Ausführungsformen einer supraleitenden Magnetanordnung erläutert, welche im Probenvolumen je ein Magnetfeld der Stärke 9.4 Tesla erzeugen. Als Supraleitermaterial wird Niob-Titan eingesetzt. Der Magnet wird in einem Flüssighelium-Bad betrieben bei einer Temperatur von 4.2 Kelvin.

Die erste Magnetanordnung (im Weiteren Ausführungsform *"V1"* genannt) umfasst ein Magnetspulensystem *C* mit 3 Magnetsektionen gleicher Polarität. Damit das Feld im Probenvolumen homogen wird, ist in der mittleren Sektion ein Bereich halber Stromdichte (Halfnotch) vorgesehen. Bei der Ausführungsform *V1* handelt es sich um ein herkömmliches Magnetspulensystem. Der Magnetstrom für diese Anordnung beträgt 77.2 Ampere, die freie Innenbohrung hat einen Durchmesser von 80 Millimetern.

Tabelle 1 zeigt die wichtigsten Merkmale der Magnetanordnung in der Ausführungsform *V1*.

**Tabelle 1**

|  | Sektion 1 | Sektion 2 | Sektion 3 | Halfnotch |
|---|---|---|---|---|
| *ri* [Millimeter] | 40.0 | 67.0 | 99.2 | 70.7 |
| *ra* [Millimeter] | 59.9 | 92.2 | 122.9 | 81.1 |
| *L* [Millimeter] | 420 | 420 | 420 | 157.3 |
| *W* | 332 | 599 | 599 | 224 |
| *N* | 24 | 34 | 32 | 14 |

In der Tabelle 1 bezeichnen:

*ri*    den Innenradius der Solenoidspule,

*ra*    den Außenradius der Solenoidspule,

*L*    die Länge der Solenoidspule,

*W*    die Anzahl Draht-Windungen auf jeder Lage der Solenoidspule,

*N*    die Anzahl Drahtlagen der Solenoidspule.

Mit der Variante *V1* wird eine erfindungsgemäße Variante (im Weiteren *"V2"* genannt) verglichen, welche neben dem Magnetspulensystem *C* eine Feldformvorrichtung *P* umfasst. Im vorliegenden Beispiel ist das Magnetspulensystem *C* in den radialen Maßen identisch mit demjenigen der Variante *V1* und die Feldformvorrichtung *P* besteht aus 2 Ringen aus Weicheisen, welche rein axial magnetisiert und magnetisch gesättigt sind (Sättigungsinduktion = 2.15 Tesla). Diese Ringe haben einen Durchmesser von 70 Millimetern, eine Wandstärke von 0.1 Millimetern und eine axiale Länge von 33.5 Millimetern. Sie liegen axial 33 Millimeter auseinander und sind symmetrisch zum magnetischen Zentrum angeordnet. Von Bedeutung ist vor allem ihr Feldbeitrag $H_4 \cdot z^4$, welcher im Probenvolumen proportional zur vierten Potenz von *z* variiert. Dank dieses Beitrags kann der Halfnotch in der mittleren Magnetsektion kürzer gemacht werden, was eine Verkürzung der Magnetsektionen erlaubt. Der Strom ist mit 77.5 Ampere vergleichbar mit jenem der Variante *V1*.

Tabelle 2 zeigt die wichtigsten Merkmale der Magnetanordnung in der Ausführungsform *V2*.

**Tabelle 2**

|  | Sektion 1 | Sektion 2 | Sektion 3 | Halfnotch |
|---|---|---|---|---|
| *ri* [Millimeter] | 40.0 | 67.0 | 99.2 | 70.7 |
| *ra* [Millimeter] | 59.9 | 92.2 | 122.9 | 81.1 |
| *L* [Millimeter] | 379 | 379 | 379 | 112.8 |
| *W* | 300 | 540 | 540 | 161 |
| *N* | 24 | 34 | 32 | 14 |

In der Tabelle 2 bezeichnen:

*ri*    den Innenradius der Solenoidspule,

*ra*    den Außenradius der Solenoidspule,

*L*    die Länge der Solenoidspule,

*W*    die Anzahl Draht-Windungen auf jeder Lage der Solenoidspule,

*N*    die Anzahl Drahtlagen der Solenoidspule.

Ein Vergleich der Tabellen 1 und 2 zeigt, dass der Einsatz der Feldformvorrichtung *P* zu einer Längenreduktion der Solenoidspulen von rund 10% führt. Bei der Ausführungsform *V1* hat der Bereich auf der *z*-Achse mit einer Feldvariation von weniger als 0.1 ppm eine Länge von 27 Millimetern, bei der Ausführungsform *V2* ist dieser Bereich 28 Millimeter lang. Mit der Feldformvorrichtung kann also bei gleichbleibender Homogenität 10% Supraleiterdraht gespart werden.

Allerdings ist der Einsatz einer Feldformvorrichtung erst dann sinnvoll, wenn diese keine zu großen unerwünschten Feldinhomogenitäten erzeugt. Solche Inhomogenitäten kommen durch die unvermeidlichen produktionsbedingten Ungenauigkeiten zustande. Im Folgenden wird hergeleitet, wie genau die Feldformvorrichtung angefertigt werden muss, damit die Homogenität der Magnetanordnung immer noch akzeptabel bleibt.

Die *z*-Komponente $B_z$ des Magnetfeldes kann um das magnetische Zentrum nach Kugelfunktionen entwickelt werden:

$$B_z(r,z,\varphi) = \sum_{n=0}^{\infty} \sum_{m=0}^{n} P_n^m \left( \frac{z}{\sqrt{r^2 + z^2}} \right) (r^2 + z^2)^{n/2} \left( A_{nm} \cos(m\varphi) + B_{nm} \sin(m\varphi) \right)$$

wobei $P^m_n$ die zugeordneten Legendre Funktionen sind. Die Koeffizienten $A_{nm}$ und $B_{nm}$ nennt man Gradienten. *n* heißt der Grad, *m* die Ordnung der Legendre Funktion $P_n^m$. $A_{00}$ ist die *z*-Komponente des Magnetfeldes im magnetischen Zentrum. Verschwinden alle Koeffizienten $A_{nm}$ und $B_{nm}$ für $0 < n \le k\text{-}1$, spricht man von einer Homogenität *k*-ten Grades. Dieser Homogenitätsgrad wird theoretisch mit einem geeigneten Design der Magnetanordnung erreicht. Da aber unvermeidliche produktionstechnische Ungenauigkeiten auftreten, wird das tatsächliche Feldprofil einer Magnetanordnung von dieser idealen Form abweichen. Um diese Abweichung zu kompensieren, sind in Magneten für Resonanzspektroskopie sogenannte Shimspulen vorgesehen. Jede dieser Spulen kann mit einem eigenen Strom betrieben werden, und erzeugt typischerweise genau einen bestimmten Feldgradienten im Arbeitsvolumen. Falls für alle Gradienten mit Grad $n \le k\text{-}1$ je eine Shimvorrichtung vorhanden ist, so erzeugt das Magnetspulensystem zusammen mit den Shimspulen ein Feld mit Homogenität *k*-ten Grades, sofern die Ströme in den Shimspulen richtig gesetzt sind. Die Größe der Koeffizienten *k*-ten Grades $A_{km}$ und $B_{km}$ ist ein Maß für die verbleibende Inhomogenität des Magneten nach dem Shimmen. In einer Magnetanordnung mit einem durch Notches homogenisierten Magnetspulensystem (wie in der Variante *V1* der obigen beiden Beispiele) hängt die Größe der verbleibenden Gradienten $A_{km}$ und $B_{km}$ im Wesentlichen davon ab, um wieviel die Magnetwindungen im Spulensystem von ihrer theoretisch vorgesehenen Position abweichen können. In einer erfindungsgemäßen Magnetanordnung (wie in der Variante *V2* der obigen beiden Beispiele) können nun Fertigungsungenauigkeiten der magnetischen Feldformvorrichtung einen zusätzlichen unerwünschten Beitrag zu den verbleibenden Gradienten $A_{km}$ und $B_{km}$ leisten. Damit diese potentielle Verschlechterung der Feldhomogenität der geshimten Magnetanordnung in einem tolerierbaren Rahmen bleibt, werden sehr hohe Anforderungen an die Fertigungsgenauigkeit von erfindungsgemäßen magnetischen Feldformvorrichtungen gestellt.

Im Folgenden wird ein Verfahren aufgezeigt, mit welchem ein Maß für die einzuhaltende Fertigungsgenauigkeit der Feldformvorrichtung berechnet werden kann. Die Idee dieses Verfahrens ist es, zuerst einen quantitativen Zusammenhang herzustellen zwischen der Größenordnung der vom Magnetspulensystem erzeugten Gradienten $A_{km}$ und $B_{km}$ einerseits und der Fertigungsgenauigkeit $\Delta_C$ für die maximale (radiale oder axiale) Verschiebung eines Volumenelementes *dV* der Magnetwicklung im Magnetspulensystem andererseits. Analog dazu wird ein Zusammenhang hergestellt zwischen den entsprechenden, von der Feldformvorrichtung erzeugten, Gradienten einerseits und der Fertigungsgenauigkeit $\Delta_P$ für die maximale (radiale oder axiale) Verschiebung eines Volumenelementes *dV* der Feldformvorrichtung *P* andererseits. Ferner wird verlangt, dass die zusätzlich von der Feldformvorrichtung erzeugten Gradienten eine obere Grenze von 20 Prozent der vom Magnetspulensystem erzeugten Gradienten $A_{km}$ und $B_{km}$ nicht überschreiten. Aus dieser Bedingung kann ein Grenzwert für $\Delta_P$ berechnet werden, sofern ein realistischer Wert für die Größe $\Delta_C$ bekannt ist. Im Folgenden müssen nun also die Zusammenhänge zwischen den Fertigungsgenauigkeiten $\Delta_C$ und $\Delta_P$ einerseits und den Stärken der erzeugten Gradienten andererseits hergeleitet werden.

Ein infinitesimales Volumen $dV$ an einem Ort $(r,z,\varphi)$, welches von einer Stromdichte $J$ in azimutaler Richtung durchflossen wird, erzeugt bezogen auf den Koordinatenursprung Gradienten der Größe

$$A_{nm} = \cos(m\varphi)\frac{f_{nm}\left(\dfrac{z}{r}\right)}{\left(r^2 + z^2\right)^{1+n/2}} J\,dV$$

$$B_{nm} = \sin(m\varphi)\frac{f_{nm}\left(\dfrac{z}{r}\right)}{\left(r^2 + z^2\right)^{1+n/2}} J\,dV$$

mit Funktionen $f_{nm}$, die nur vom Verhältnis $z/r$ abhängen. Die wesentliche Erkenntnis, die aus diesen Formeln gewonnen werden kann, ist, dass die Gradienten invers proportional zur $n$-ten Potenz des Abstandes des stromdurchflossenen Volumenelementes zum Koordinatenursprung sind. Der Koordinatenursprung wird sinnvollerweise im magnetischen Zentrum der Magnetanordnung angesiedelt. Für ein Magnetspulensystem $C$, dessen Drahtwindungen maximal um einen Betrag $\Delta_C$ von der theoretisch vorgesehenen Lage abweichen, ist die folgende Größe ein Maß für die Differenz zwischen den tatsächlichen und den theoretischen Gradienten $n$-ten Grades, welche vom Spulensystem im Arbeitsvolumen erzeugt werden:

$$\iiint\limits_{C}\left|\Delta_C(r,z,\varphi)\right| \cdot \frac{\left|J_C(r,z,\varphi)\right|}{(r^2 + z^2)^{1+n/2}}\,dV$$

mit

$J_C$    Stromdichte im Magnetspulensystem $C$,
$r$      radialer Abstand des Volumenelementes $dV$ von der $z$-Achse,
$\varphi$    azimutaler Winkel des Volumenelementes $dV$,

$\iiint\limits_{C}\ldots dV$ Volumenintegral über das Volumen des Magnetspulensystems $C$.

Analog dazu ist für eine Feldformvorrichtung $P$, deren Oberflächen maximal um einen Betrag $\Delta_P$ von den theoretisch vorgesehenen Oberflächen abweichen, die folgende Größe ein Maß für die Differenz zwischen den tatsächlichen und den theoretischen Gradienten $n$-ten Grades, welche von der Feldformvorrichtung im Arbeitsvolumen erzeugt werden:

$$\iiint\limits_{P}\left|\Delta_P(r,z,\varphi)\right| \frac{\left|\vec{\nabla} \times \vec{M}(r,z,\varphi)\right|}{(r^2 + z^2)^{1+n/2}}\,dV$$

mit

$\vec{M}$    Magnetisierung der Feldformvorrichtung $P$,

$$\iiint\limits_{P} \cdots dV$$ Volumenintegral über das Volumen der Feldformvorrichtung $P$.

Der Ausdruck für die Gradientenstärken der Feldformvorrichtung wurde aus jenem für das Magnetspulensystem hergeleitet, indem mit dem Vektor $\vec{\nabla} \times \overline{M}(r, z, \varphi)$ jene Stromdichteverteilung anstelle von $J_c$ eingesetzt wurde, welche dasselbe $B$-Feld erzeugt wie das magnetische Material der Feldformvorrichtung.

Falls in einer Magnetanordnung die Gradienten mit Grad $n \leq k\text{-}1$ mit Hilfe einer Shimvorrichtung kompensiert werden, so dürfen insbesondere die unshimbaren Gradienten $k$-ter Ordnung durch die Feldformvorrichtung nicht wesentlich (vorzugsweise um weniger als 20 Prozent) verstärkt werden. Für die Fertigungstoleranz $\Delta_P$ der Feldformvorrichtung $P$ gilt daher:

$$\Delta_P < 0.2\Delta_C \cdot \frac{\iiint\limits_{C} \dfrac{\left| J_C(r, z, \varphi) \right|}{(r^2 + z^2)^{1+k/2}} dV}{\iiint\limits_{P} \dfrac{\left| \vec{\nabla} \times \overline{M}(r, z, \varphi) \right|}{(r^2 + z^2)^{1+k/2}} dV}$$

Dies gilt unter der vereinfachenden Annahme, dass sowohl $\Delta_P$ als auch $\Delta_C$ ortsunabhängig sind.

Mit diesem Verfahren soll nun die einzuhaltende Fertigungsgenauigkeit für die erfindungsgemäße Feldformvorrichtung im Falle des obigen Beispieles (Variante $V2$) berechnet werden. In diesem Beispiel ist die Stromdichte $J_C$ im Spulensystem gebietsweise ortsunabhängig und $\vec{\nabla} \times \overline{M}(r, z, \varphi)$ führt auf zwei Schichten mit konstanter Stromdichte. Die Magnetanordnung sei mit einem Shimsystem ausgerüstet, welches alle Gradienten bis und mit dritten Grades korrigiert. Deshalb kann $k = 4$ gesetzt werden. Der Quotient aus den beiden Integralen in obiger Formel berechnet sich numerisch zu 0.5, weshalb für die Fertigungstoleranz $\Delta_P$ der Feldformvorrichtung resultiert:

$$\Delta_P < 0.1 \ \Delta_C \ .$$

Beträgt die Genauigkeit $\Delta_C$ der Wicklungen des Magnetspulensystems 0.1 Millimeter, ist also die Einhaltung einer maximalen Fertigungstoleranz $\Delta_P$ von 0.01 Millimetern für die Feldformvorrichtung erforderlich.

Erst dank diesem Verfahren zur Berechnung der notwendigen Fertigungsgenauigkeit der magnetischen Feldformvorrichtung kann nun ein geeignetes Herstellungsverfahren für die Feldformvorrichtung bestimmt werden, um so eine erfindungsgemäße Magnetanordnung für hochauflösende Magnetresonanzspektroskopie zu verwirklichen, welche sich die Vorteile einer magnetischen Feldformvorrichtung zu Nutze macht und gleichzeitig den hohen Anforderungen an die Feldhomogenität im Arbeitsvolumen genügen kann.

**Patentansprüche**

**1.** Magnetanordnung mit einem supraleitenden Magnetspulensystem ($C$) zur Erzeugung eines Magnetfeldes in Richtung einer $z$-Achse in einem auf der $z$-Achse um $z = 0$ angeordneten Arbeitsvolumen ($AV$), wobei das Feld des Magnetspulensystems ($C$) im Arbeitsvolumen ($AV$) mindestens einen inhomogenen Anteil $H_n \cdot z^n$ mit $n \geq 2$ aufweist, dessen Beitrag zur Gesamtfeldstärke auf der $z$-Achse um $z = 0$ mit der $n$-ten Potenz von $z$ variiert, und wobei eine bezüglich der $z$-Achse bis auf eine Fertigungstoleranz zylindersymmetrische Feldformvorrichtung ($P$) aus magnetischem Material vorgesehen ist,
**dadurch gekennzeichnet,**
**dass** die Feldformvorrichtung ($P$) mindestens teilweise einen radialen Abstand von der $z$-Achse von weniger als 80 Millimetern aufweist und mindestens einen der inhomogenen Feldanteile $H_n \cdot z^n$ des Magnetspulensystems ($C$) zu mindestens fünfzig Prozent kompensiert, dass mindestens ein zusätzliches Spulensystem (S) vorgesehen ist, welches in der Magnetanordnung als Shim-Vorrichtung wirkt, und dass die tatsächlichen Oberflächen der Feldformvorrichtung (P) an jedem Ort um höchstens Δp von den vorgesehenen Oberflächen abweichen, wobei Δp durch

$$\Delta_P = 0.2 \cdot \frac{\iiint\limits_C |\Delta_C(r,z,\varphi)| \cdot \dfrac{|J_C(r,z,\varphi)|}{(r^2+z^2)^{1+k/2}}\, dV}{\iiint\limits_P \dfrac{|\vec{\nabla}\times\vec{M}(r,z,\varphi)|}{(r^2+z^2)^{1+k/2}}\, dV}$$

.

gegeben ist, mit

$\Delta_C$ Fertigungstoleranz für die maximale (radiale oder axiale) Verschiebung eines Volumenelementes $dV$ der Magnetwicklung im Magnetspulensystem ($C$),
$k$ niedrigster Grad außer Null all jener Koeffizienten des Feldes des Magnetspulensystems ($C$) in der Entwicklung nach Kugelfunktionen, zu deren Kompensation kein Shimspulensystem ($S$) vorgesehen ist, wobei der Grad den unteren Index der, in der entsprechenden Kugelfunktion auftretenden, Legendre-Funktion $P_k^m$ bezeichnet,
$J_C$ Stromdichte im Magnetspulensystem ($C$),

$\vec{M}$ Magnetisierung der Feldformvorrichtung ($P$),
$r$ radialer Abstand des Volumenelementes $dV$ von der $z$-Achse,
$\varphi$ azimutaler Winkel des Volumenelementes $dV$.

$\iiint\limits_C \dots dV$ bzw. $\iiint\limits_P \dots dV$ Volumenintegral über das Volumen des Magnetspulensystems ($C$) bzw. der Feldformvorrichtung ($P$).

2. Magnetanordnung nach Anspruch 1, **dadurch gekennzeichnet, dass** das Magnetspulensystem ($C$) eine aktive Abschirmung besitzt.

3. Magnetanordnung nach einem der vorhergehenden Ansprüche, **dadurch gekennzeichnet, dass** die Feldformvorrichtung ($P$) mindestens teilweise radial innerhalb der innersten Drahtwindung des Magnetspulensystems ($C$) angeordnet ist.

4. Magnetanordnung nach einem der vorhergehenden Ansprüche, **dadurch gekennzeichnet, dass** die Feldformvorrichtung ($P$) magnetisch vollständig gesättigt und rein axial magnetisiert ist.

5. Magnetanordnung nach Anspruch 4, **dadurch gekennzeichnet, dass** die Feldformvorrichtung ($P$) einen Ring umfasst, insbesondere aus einem Ring besteht, welcher sich auf einem Radius a befindet und sich axial zwischen $-z_1$ und $z_1$ erstreckt, wobei $z_1 > a$.

6. Magnetanordnung nach Anspruch 4, **dadurch gekennzeichnet, dass** die Feldformvorrichtung ($P$) zwei Ringe umfasst, insbesondere aus zwei Ringen besteht, welche sich auf einem Radius a befinden, und sich axial zwischen $z_1$ und $z_2$ bzw. zwischen $-z_2$ und $-z_1$ erstrecken, wobei $0.42\,a < z_1 < 0.46\,a$ und $a < z_2$.

7. Magnetanordnung nach einem der vorhergehenden Ansprüche, **dadurch gekennzeichnet, dass** die Feldformvorrichtung ($P$) Komponenten aus Weicheisen umfasst.

8. Magnetanordnung nach einem der vorhergehenden Ansprüche, **dadurch gekennzeichnet, dass** die Feldformvorrichtung ($P$) magnetische Folien umfasst, welche auf einer Trägervorrichtung angebracht sind.

9. Verfahren zur Bestimmung der Fertigungstoleranzen der Feldformvorrichtung ($P$) in einer Magnetanordnung nach einem der vorhergehenden Ansprüche, **dadurch gekennzeichnet, dass** die Größe $\Delta_P$, welche die maximale Fertigungstoleranz der tatsächlichen Oberflächen der Feldformvorrichtung ($P$) an jedem Ort bezeichnet, berechnet

wird, wobei $\Delta_P$ durch

$$\Delta_P = 0.2 \cdot \frac{\iiint\limits_{C} |\Delta_C(r,z,\varphi)| \cdot \frac{|J_C(r,z,\varphi)|}{(r^2+z^2)^{1+k/2}} dV}{\iiint\limits_{P} \frac{|\overline{\nabla} \times \overline{M}(r,z,\varphi)|}{(r^2+z^2)^{1+k/2}} dV}$$

gegeben ist, mit

$\Delta_C$ Fertigungstoleranz für die maximale (radiale oder axiale) Verschiebung eines Volumenelementes $dV$ der Magnetwicklung im Magnetspulensystem ($C$),

$k$ niedrigster Grad außer Null all jener Koeffizienten des Feldes des Magnetspulensystems ($C$) in der Entwicklung nach Kugelfunktionen, zu deren Kompensation kein Shimspulensystem ($S$) vorgesehen ist, wobei der Grad den unteren Index der, in der entsprechenden Kugelfunktion auftretenden, Legendre-Funktion $P_k^m$ bezeichnet,

$J_C$ Stromdichte im Magnetspulensystem ($C$),

$\overline{M}$ Magnetisierung der Feldformvorrichtung ($P$),

$r$ radialer Abstand des Volumenelementes $dV$ von der $z$-Achse,

$\varphi$ azimutaler Winkel des Volumenelementes $dV$.

$\iiint\limits_{C} \ldots dV$ bzw. $\iiint\limits_{P} \ldots dV$ : Volumenintegral über das Volumen des Magnetspulensystems ($C$) bzw. der Feldformvorrichtung ($P$).

**10.** Apparatur zur hochauflösenden Magnetresonanz-Spektroskopie, **dadurch gekennzeichnet, dass** die Apparatur eine Magnetanordnung gemäß einem der Ansprüche 1 bis 8 umfasst.

## Claims

**1.** Magnet arrangement comprising a superconducting magnet coil system ($C$) for producing a magnetic field in the direction of a z axis, in a working volume (AV) disposed on the z axis about z=0, wherein the field of the magnet coil system (C) in the working volume (AV) has at least one inhomogeneous portion $H_n \cdot z^n$ with $n \geq 2$ whose contribution to the total field strength on the z axis about z=0 varies with the nth power of z, and whereby a field shaping device (P) of magnetic material is provided, which is substantially cylindrically symmetrical with respect to the z axis except for production tolerances, **characterized in that**, the field shaping device (P) has, at least in parts, a radial separation from the z axis of less than 80mm and compensates for at least one of the inhomogeneous field portions $H_n \cdot z^n$ of the magnet coil system (C) by at least 50%, wherein at least one additional coil system (S) is provided which acts as shim device in the magnet arrangement, and the actual surfaces of the field shaping device (P) differ at all locations by not more than $\Delta_P$ from the desired surfaces, wherein $\Delta_P$ is given by

$$\Delta_P = 0.2 \cdot \frac{\iiint\limits_{C} |\Delta_C(r,z,\varphi)| \cdot \frac{|J_C(r,z,\varphi)|}{(r^2+z^2)^{k/2}} dV}{\iiint\limits_{P} \frac{|\overline{\nabla} \times \overline{M}(r,z,\varphi)|}{(r^2+z^2)^{k/2}} dV}$$

with

$\Delta_C$ Production tolerance for the maximum (radial or axial) displacement of a volume element $dV$ of the magnet winding in the magnet coil system (C),

$k$ lowest degree, except for zero, of all those coefficients of the field of the magnet coil system (C) in the expansion according to spherical harmonic functions, which are not compensated for by a shim coil system (S), wherein the degree designates the lower index of the Legendre function $P_k^m$ which occurs in the associated spherical harmonic,

$J_C$ current density in the magnet coil system (*C*),

$\overrightarrow{M}$ magnetization of the field shaping device (*P*),

$r$ radial separation between the volume element $dV$ and the $z$ axis,

$\varphi$ azimuthal angle of the volume element $dV$.

$\iiint_C ...dV$ and $\iiint_P ...dV$ : volume integral over the volume of the magnet coil system (*C*) and the field shaping device (*P*), respectively.

2. Magnet arrangement according to claim 1, **characterized in that** the magnet coil system (*C*) has an active shielding.

3. Magnet arrangement according to any one of the preceding claims, **characterized in that** the field shaping device (P) is disposed at least partially within the innermost wire winding of the magnet coil system (C).

4. Magnet arrangement according to any one of the preceding claims, **characterized in that** the field shaping device (P) is magnetically completely saturated and magnetized only in the axial direction.

5. Magnet arrangement according to claim 4, **characterized in that** the field shaping device (P) comprises a ring, in particular, consists of a ring, which is located on a radius a and extends axially between $-z_1$ and $z_1$, wherein $z_1 > a$.

6. Magnet arrangement according to claim 4, **characterized in that** the field shaping device (P) comprises two rings, in particular, consists of two rings, which are located on a radius a and which extend axially between $z_1$ and $z_2$ and between $-z_2$ and $-z_1$, wherein $0.42\,a < z_1 < 0.46\,a$ and $a < z_2$.

7. Magnet arrangement according to any one of the preceding claims, **characterized in that** the field shaping device (P) comprises components of soft iron.

8. Magnet arrangement according to any one of the preceding claims, **characterized in that** the field shaping device (P) comprises magnetic foils mounted onto a carrier device.

9. Method for determining the production tolerances of the field shaping device (*P*) in a magnet arrangement according to any one of the preceding claims, **characterized in that** the value $\Delta_P$, which designates the maximum production tolerances of the actual surfaces of the field shaping device (*P*) at any location, is calculated, wherein $\Delta_P$ is given by

$$\Delta_P = 0.2 \cdot \frac{\iiint_C |\Delta_C(r,z,\varphi)| \cdot \dfrac{|J_C(r,z,\varphi)|}{(r^2 + z^2)^{k/2}} \, dV}{\iiint_P \dfrac{|\overrightarrow{\nabla} \times \overrightarrow{M}(r,z,\varphi)|}{(r^2 + z^2)^{k/2}} \, dV}$$

with

$\Delta_C$ production tolerance for the maximum (radial or axial) displacement of a volume element $dV$ of the magnet winding in the magnet coil system (*C*),

*k* lowest degree, except for zero, of all those coefficients of the field of the magnet coil system (*C*) in an expansion according to spherical harmonic functions, which are not compensated for by a shim coil system (*S*), wherein the degree designates the lower index of the Legendre function $P_k^m$ occurring in the corresponding spherical harmonic function,

$J_C$ current density in the magnet coil system (*C*),

$\overrightarrow{M}$ magnetization of the field shaping device (*P*),

*r* radial separation between the volume element *dV* and the *z*-axis,

φ azimuthal angle of the volume element *dV*.

$$\iiint_C ...dV \text{ and } \iiint_P ...dV :$$ volume integral over the volume of the magnetic coil system (*C*) and of the field shaping device (*P*), respectively.

**10.** Apparatus for high-resolution magnetic resonance spectroscopy, **characterized in that** the apparatus comprises a magnet arrangement in accordance with any one of the claims 1 through 8.

**Revendications**

**1.** Agencement d'aimants avec un système de bobines magnétiques supraconductrices (C) pour générer un champ magnétique en direction d'un axe z dans un volume de travail (*AV*) situé sur l'axe *z* autour de *z* = 0, dans lequel le champ du système de bobines magnétiques (C) présente dans le volume de travail (*AV*) au moins une composante inhomogène $H_n \cdot z^n$ avec $n \geq 2$ dont la contribution à l'intensité de champ totale sur l'axe z autour de *z = 0* varie avec la puissance *nième* de *z*, et dans lequel il est prévu un dispositif de configuration de champ (*P*) en matériau magnétique, cylindrosymétrique à une tolérance de fabrication près par rapport à l'axe *z*,

**caractérisé par le fait**

**que** le dispositif de configuration de champ (*P*) présente au moins en partie une distance radiale de l'axe *z* inférieure à 80 millimètres et compense au moins une des composantes inhomogènes $H_n \cdot z^n$ du système de bobines magnétiques (C) à au moins cinquante pour cent, qu'il est prévu au moins un système de bobines (S) supplémentaire qui fait fonction de dispositif de shim dans l'agencement d'aimants, et que les surfaces réelles du dispositif de configuration de champ (*P*) s'écartent en tout lieu des surfaces prévues au maximum de Δ*p*, Δ*p* étant donné par

$$\Delta_p = 0{,}2 \frac{\iiint_C \left|\Delta_C(r,z,\varphi)\right| \cdot \dfrac{\left|J_C(r,z,\varphi)\right|}{(r^2+z^2)^{1+k/2}} dV}{\iiint_P \dfrac{\left|\overrightarrow{\nabla} \times \overline{M}(r,z,\varphi)\right|}{(r^2+z^2)^{1+k/2}} dV} .$$

avec

$\Delta_C$ tolérance de fabrication pour le déplacement maximum (radial ou axial) d'un élément de volume *dV* de l'enroulement magnétique dans le système de bobines magnétiques (C),

*k* plus petit degré non nul de tous les coefficients du champ du système de bobines magnétiques (C) dans le développement en fonctions sphériques pour la compensation desquels il n'est pas prévu de bobines de shim (S), le degré désignant l'indice inférieur de la fonction de Legendre $P_k^m$ qui apparaît dans la fonction sphérique correspondante,

$J_C$ densité de courant dans le système de bobines magnétiques (C),

$\overline{M}$ magnétisation du dispositif de configuration de champ (*P*),

*r* distance radiale de l'élément de volume *dV* de l'axe *z*,

φ angle azimutal de l'élément de volume *dV*,

$$\iiint_C \cdots dV \ \text{resp.} \ \iiint_P \cdots dV$$ intégrale de volume sur le volume du système de bobines magnétiques (*C*) resp. du dispositif de configuration de champ (*P*).

2.  Agencement d'aimants selon la revendication 1, **caractérisé par le fait que** le système de bobines magnétiques (C) possède un écrantage actif.

3.  Agencement d'aimants selon l'une des revendications précédentes, **caractérisé par le fait que** le dispositif de configuration de champ (*P*) est disposé au moins en partie radialement à l'intérieur de la spire de fil la plus interne du système de bobines magnétiques (C).

4.  Agencement d'aimants selon l'une des revendications précédentes, **caractérisé par le fait que** le dispositif de configuration de champ (*P*) est entièrement saturé magnétiquement et magnétisé uniquement axialement.

5.  Agencement d'aimants selon la revendication 4, **caractérisé par le fait que** le dispositif de configuration de champ (*P*) comprend un anneau, en particulier est constitué d'un anneau qui se trouve sur un rayon a et s'étend axialement entre -$z_1$ et $z_1$, avec $z_1 > a$.

6.  Agencement d'aimants selon la revendication 4, **caractérisé par le fait que** le dispositif de configuration de champ (*P*) comprend deux anneaux, en particulier est constitué de deux anneaux qui se trouvent sur un rayon *a* et s'étendent axialement entre $z_1$ et $z_2$ et entre -$z_1$ et -$z_2$, avec $0{,}42\ a < z1 < 0{,}46\ a$ et $a < z_2$.

7.  Agencement d'aimants selon l'une des revendications précédentes, **caractérisé par le fait que** le dispositif de configuration de champ (*P*) comprend des composants en fer doux.

8.  Agencement d'aimants selon l'une des revendications précédentes, **caractérisé par le fait que** le dispositif de configuration de champ (*P*) comprend des feuilles magnétiques qui sont appliquées sur un dispositif de support.

9.  Procédé pour déterminer les tolérances de fabrication du dispositif de configuration de champ (*P*) dans un agencement d'aimants selon l'une des revendications précédentes, **caractérisé par le fait que** la grandeur $\Delta_p$ qui désigne la tolérance de fabrication maximale des surfaces réelles du dispositif de configuration de champ (*P*) en tout lieu est calculée, $\Delta_p$ étant donné par

$$\Delta_p = 0{,}2 \frac{\iiint_C \Delta_C(r,z,\varphi) \cdot \dfrac{\left| J_C(r,z,\varphi) \right|}{\left(r^2 + z^2\right)^{1+k/2}} dV}{\iiint_P \dfrac{\left| \vec{\nabla} \times \overline{M}(r,z,\varphi) \right|}{\left(r^2 + z^2\right)^{1+k/2}} dV}$$

avec

$\Delta_C$ tolérance de fabrication pour le déplacement maximum (radial ou axial) d'un élément de volume *dV* de l'enroulement magnétique dans le système de bobines magnétiques (C),

*k* plus petit degré non nul de tous les coefficients du champ du système de bobines magnétiques (C) dans le développement en fonctions sphériques pour la compensation desquels il n'est pas prévu de système de bobines de shim (S), le degré désignant l'indice inférieur de la fonction de Legendre $P_k^m$ qui apparaît dans la fonction sphérique correspondante,

$J_C$ densité de courant dans le système de bobines magnétiques (C),

$\overline{M}$ magnétisation du dispositif de configuration de champ (*P*),

*r* distance radiale de l'élément de volume *dV* de l'axe *z*,

φ angle azimutal de l'élément de volume *dV,*

$$\iiint_{C} \cdots dV \ \text{resp.} \ \iiint_{P} \cdots dV$$ intégrale de volume sur le volume du système de bobines magnétiques (C)

resp. du dispositif de configuration de champ (*P*).

**10.** Appareillage pour la spectroscopie par résonance magnétique à haute résolution **caractérisé par le fait que** l'appareillage comprend un agencement d'aimants selon l'une des revendications 1 à 8.

Fig. 1

Fig. 2